(19) Europäisches Patentamt
European Patent Office
Office européen des brevets

(11) **EP 1 674 878 B1**

(12) **FASCICULE DE BREVET EUROPEEN**

(45) Date de publication et mention
de la délivrance du brevet:
**03.09.2008 Bulletin 2008/36**

(51) Int Cl.:
*G01R 33/032* (2006.01)    *G01R 15/24* (2006.01)
*G01R 29/08* (2006.01)

(21) Numéro de dépôt: **05111366.0**

(22) Date de dépôt: **28.11.2005**

(54) **Sonde électro-optique de mesure de champs électriques ou électromagnétiques à asservissement de la longueur d'onde du point de fonctionnement**

Elektrooptische Sonde zur Messung elektrischer oder elektromagnetischer Felder mit einer Steuerung der Wellenlänge des Betriebspunkts

Electro-optical probe for measuring electrical or electromagnetic fields with control of the wavelength of the working point

(84) Etats contractants désignés:
**DE FR GB IT**

(30) Priorité: **22.12.2004 FR 0413733**

(43) Date de publication de la demande:
**28.06.2006 Bulletin 2006/26**

(73) Titulaire: **THALES**
**92200 Neuilly sur Seine (FR)**

(72) Inventeurs:
• **BREUIL, Nicolas**
**91400, ORSAY (FR)**
• **DUVILLARET, Lionel**
**73000, CHAMBERY (FR)**

(74) Mandataire: **Lucas, Laurent Jacques et al**
**Marks & Clerk France**
**31-33 Avenue Aristide Briand**
**94117 Arcueil Cedex (FR)**

(56) Documents cités:
**US-A- 5 272 434       US-A- 5 933 000**

• **WAKANA SHINICHI MEMBER; OHARA TAKUYA; ABE MARI; YAMAZAKI ETSUSHI; KISHI MASATO; TSUCHIYA MASAHIRO MEMBER, IEEE: "Fiber-Edge Electrooptic/Magnetooptic Probe for Spectral-Domain Analysis of Electromagnetic Field" IEEE TRANSACTIONS ON MICROWAVE THEORY AND TECHNIQUES, vol. 48, no. 12, décembre 2000 (2000-12), pages 2611-2615, XP011038198**
• **MAZZOLA M S ET AL: "Gallium-arsenide optically isolated electric field sensor for utility and pulsed power applications" 1995 PULSED POWER CONFERENCE. ALBUQUERQUE, JULY 3 - 6, 1995, PULSED POWER CONFERENCE, NEW YORK, IEEE, US, vol. VOL. 2, 3 juillet 1995 (1995-07-03), pages 372-377, XP010227697 ISBN: 0-7803-2791-8**

EP 1 674 878 B1

**Description**

La présente invention concerne le domaine des dispositifs permettant d'effectuer des mesures ponctuelles de l'intensité d'un champ électrique, magnétique ou électromagnétique présent dans une zone donnée de l'espace. Elle trouve son application dans des domaines où la cartographie dans l'espace d'un champ électrique ou électromagnétique revêt une importance comme par exemple dans le domaine des tests de compatibilité électromagnétique, les activités de cartographie du rayonnement d'antennes radar ou de mesures du champ créé par des sources micro-ondes de forte puissance ou encore les mesures de taux d'absorption des ondes électromagnétiques sur les être vivants, effectuées par exemple dans le domaine des télécommunications mobiles de type GSM, GPRS, etc. L'invention trouve également un champ d'application dans les mesures de fonctions de transfert de composants hyperfréquence, amplificateurs ou lignes de transmission par exemple, montés sur circuits imprimés.

Certains des systèmes de mesure actuels permettant d'effectuer des mesures ponctuelles de champ électrique ou électromagnétique reposent sur une détection de champ réalisée au moyen d'une diode détectrice hyperfréquence large bande. Ces systèmes présentent l'avantage d'être faciles à mettre en oeuvre pour un coût relativement faible. En revanche, ils présentent l'inconvénient d'opérer une réponse qui varie, en fonction du niveau du champ détecté, d'une détection quadratique lorsque le niveau détecté est faible à une réponse linéaire dès que le niveau détecté devient relativement important. D'autre part, s'agissant de capteurs électroniques le niveau détecté est transmis sous forme électrique ce qui peut entraîner une action parasite du champ mesuré sur le signal transmis.

Pour éviter tous ces problèmes de couplage électromagnétique entre le champ mesuré et le dispositif de mesure, certains autres systèmes de mesure utilisent des capteurs électro-optiques, la transmission du signal détecté vers les moyens de mesure étant alors, par exemple, assurée par une fibre optique. Ces systèmes de mesure présentent l'avantage de ne pas perturber le champ mesuré, et d'avoir une réponse linéaire en fonction de l'amplitude du champ mesuré. En revanche, ils utilisent généralement comme capteurs des lasers ou des modulateurs électro-optiques de type Mach Zehnder, dont le principal inconvénient, lorsqu'on souhaite disposer d'un capteur ponctuel facile à déplacer, réside dans la nécessité de disposer d'un système de contrôle de la polarisation électrique du composant qui nécessite une source de tension, de type opto-alimentation ou batterie, à proximité du capteur. La polarisation étant nécessaire pour assurer la linéarité du fonctionnement.

Le document XP010227697 (Mazzola et al. : « Gallium-arsenide optically isolated electric field sensor for utility and pulsed power applications », JULY3-6 , 1995 PULSED POWER CONFERENCE , NEW YORK, IEEE, US, 1995-07-03), présente un dispositif de mesure de champ utilisant un capteur de champ électrique, basé sur l'exploitation de l'effet FRANZ-KELDYSH ; Ce dispositif détermine la valeur du champ mesure par mesure de la variation de l'amplitude du signal lumineux appliqué au capteur du dispositif.

De même le document XP011038198 (Shinichi Wakana et al. : »Fiber-Edge Electrooptic/Magnetooptic Probe for Spectral-Domain Analysis of Electromagnetic Field » IEEE Transactions on microwave therory and techniques », vol.48., N˚12, December 2000 présente un dispositif de mesure de champ électromagnétique dans lequel le champ est mesuré par mesure de la variation d'amplitude du signal lumineux appliqué au capteur du dispositif.

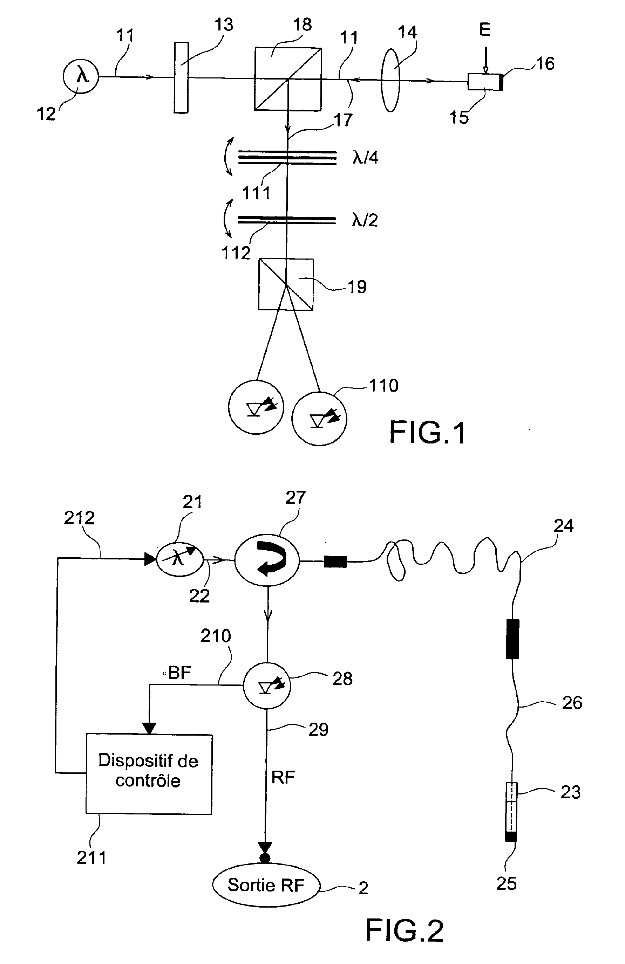

Pour effectuer des mesures de champ il est également possible d'utiliser des dispositifs mettant en oeuvre une technique connue dite de polariseur / analyseur reposant sur un principe optique de modulation de la polarisation du champ électrique de l'onde lumineuse. Ces dispositifs, dont une illustration de principe est représentée à la figure 1, mettent en oeuvre un faisceau optique 11, de longueur d'onde λ fixée, émis par une source 12. Ce faisceau passe à travers un polariseur 13 puis est focalisé au moyen d'une lentille 14 vers un cristal électro-optique 15 biréfringent, sensible à l'effet Kerr ou Pockels et présentant une surface réfléchissante 16. La polarisation optique du faisceau 11 est orientée de façon à pénétrer dans le cristal avec une orientation telle que son axe de polarisation fait un angle de 45˚ avec les axes de diélectriques propres du cristal.

Le faisceau lumineux réfléchi 17 est dirigé au moyen d'un dispositif séparateur 18 vers un analyseur 19, de type prisme de Wollaston par exemple. Le polariseur 13 et l'analyseur 19 ont par ailleurs des axes croisés.

Dans de tels dispositifs le champ électromagnétique appliqué sur le cristal biréfringent modifie les indices ordinaire et extraordinaire du matériau qui le constitue, ce qui conduit à une dépolarisation de l'onde optique 11 et à la formation de deux ondes aux polarisations linéaires et perpendiculaires entre elles, alignées selon les axes diélectriques propres du cristal et dont la vitesse de propagation le long du cristal sont différentes. Le faisceau réfléchi 17 est donc constitué de la superposition de deux ondes lumineuses et présentant un déphasage fonction de la longueur du cristal 15 et de l'amplitude du champ électromagnétique appliqué sur le cristal.

Le faisceau lumineux réfléchi 17 est transmis à l'analyseur qui délivre un signal optique dont la puissance est proportionnelle au déphasage existant entre les deux ondes constituant le faisceau réfléchi et est détecté par des éléments photoélectriques 110 de type photodiode.

L'utilisation de tels dispositifs permet avantageusement de s'affranchir de tout dispositif électrique de détection ou de polarisation et ainsi d'éviter que le champ mesuré ne subisse des perturbations. En revanche pour pouvoir exploiter un tel dispositif il est nécessaire de maîtriser la fonction de transfert propre du dispositif, fonction de transfert qui dépend en particulier du déphasage introduit par le cristal, déphasage qui varie aléatoirement au cours du temps entre 0˚ et 360˚, notamment en fonction de la température. De sorte que, pour assurer à un tel dispositif un point de fonctionnement correct, c'est à dire dans une zone linéaire de détection, il est nécessaire de polariser le dispositif.

Une solution connue pour contrôler la fonction de transfert consiste à interposer dans la voie d'analyse un dispositif déphaseur tel qu'un jeu de lames quart d'onde 111 et demi-onde 112 dont on fait varier mécaniquement l'orientation chaque lame biréfringente étant orientée de manière indépendante par rapport aux axes de polarisation des ondes formant le faisceau réfléchi. L'orientation des lames est réalisée de façon à créer entre les deux ondes réfléchies une différence de phase permettant d'obtenir une sensibilité et une linéarité optimales du dispositif.

Afin de compenser les variations introduites dans le déphasage des ondes réfléchies par les variations d'environnement du dispositif, en particulier les variations de température, un tel dispositif est généralement complété par des moyens d'asservissement de la position des lames 111 et 112. Ces moyens non représentés agissent sur l'orientation mécanique des lames de façon à corriger les variations induites sur le dispositif par le milieu ambiant.

Bien que répondant aux contraintes imposées pour effectuer une mesure ponctuelle de champ, le dispositif polariseur / analyseur décrit précédemment présente cependant d'importantes contraintes de mise en oeuvre, liées en particulier au positionnement relatif des différents éléments qui le compose. En effet dans la mesure où les faisceaux incident et réfléchi se propagent en espace libre les difficultés d'alignement optique de l'ensemble rendent ce dispositif peu déplaçable et donc par exemple peu utilisable pour établir une cartographie du champ régnant dans un espace donné. D'autre par un tel dispositif ne permet pas d'envisager un déport sur une longue distance, de plusieurs dizaines de mètre par exemple, des fonctions d'émission du faisceau incident et d'analyse du faisceau réfléchi. Or le déport du capteur électro-optique 15 du reste du dispositif, sur une distance importante, s'avère très souvent nécessaire.

Il est possible de pallier l'inconvénient lié au positionnement relatif des différents éléments du dispositif en utilisant une fibre optique à maintien de polarisation pour guider les faisceaux incident et réfléchi et rendre ainsi le dispositif facilement déplaçable. En revanche si l'on veut que la compensation des variations de déphasage des ondes réfléchies reste possible, la longueur de fibre optique utilisée doit rester courte, de l'ordre du mètre par exemple. En effet l'expérience montre qu'une longueur importante de fibre optique induit pour des variations environnementales faibles des variations de phase rapides qui ne peuvent être compensées par des moyens tels que ceux mis en oeuvre dans le dispositif de l'art antérieur illustré par la figure 1. L'introduction d'une fibre optique dans le dispositif connu de l'art antérieur ne permet donc pas aux dispositifs de type polariseur / analyseur connus de l'art antérieur de disposer d'un capteur déporté sur une grande distance.

Un but de l'invention est de résoudre le problème lié au déport du capteur dans l'utilisation d'un dispositif type polariseur / analyseur pour mesurer l'intensité d'un champ électrique, magnétique ou électromagnétique en différents points d'un espace donné. A cet effet l'invention consiste en un dispositif basé sur une technique polariseur / analyseur, comportant au moins:

- une source lumineuse de longueur d'onde variable et commandable,
- un capteur électro-optique dont un élément est constitué d'un matériau optique biréfringent, dont l'une des faces est réfléchissante,
- une fibre optique à maintien de polarisation placée entre la source lumineuse et connectée au capteur de façon à orienter l'axe de polarisation du faisceau émis dans une direction faisant un angle sensiblement égal à 45˚ par rapport aux axes diélectriques propre de la partie active du capteur,
- un élément photo-détecteur pour convertir le faisceau lumineux réfléchi par le capteur en un signal électrique proportionnel à la puissance lumineuse reçue,
- des moyens de contrôle permettant de faire varier la valeur de la longueur d'onde λ émise.

Selon l'invention, la portion biréfringente du capteur, qui décompose le faisceau émis en deux ondes aux polarisations linéaires et perpendiculaires, a une longueur effective permettant de faire varier le déphasage entre ces deux ondes entre 0˚ et 360˚ pour une variation de longueur d'onde donnée. Le faisceau réfléchi par le capteur est transmis à un élément photo-détecteur par un circulateur optique à maintien de polarisation inséré entre la source et la fibre optique. Le circulateur optique délivre un faisceau lumineux dont la puissance est fonction du déphasage entre les deux ondes réfléchies par le capteur; le signal électrique délivré par l'élément photo-détecteur est transmis aux moyens de contrôle qui utilisent ce signal pour déterminer la valeur de la longueur d'onde λ à imposer à la source.

Selon une caractéristique de l'invention, le capteur électro-optique se présente sous la forme d'un élément tubulaire ou parallélépipédique allongé comportant une zone d'extrémité assurant la connexion avec la fibre optique à maintien de polarisation, une zone biréfringente centrale induisant un déphasage entre les ondes se propageant selon des axes de polarisation différents et une zone terminale constituant le capteur de champ proprement dit.

Selon une autre caractéristique de l'invention, la longueur de la zone terminale est égale à une fraction de la longueur d'onde du champ électrique ou électromagnétique à mesurer, de façon à obtenir une sensibilité maximale du capteur.

Selon une variante de réalisation, la zone terminale comporte sur sa surface un ensemble de zones géométriques juxtaposées, revêtues d'une couche de matériau résistif ou d'une couche métallique et formant une antenne adaptée à la longueur d'onde du champ à mesurer.

Selon une autre variante de réalisation le capteur travaille en transmission et comporte deux fibres optiques, une fibre de polarisation du faisceau optique incident et une fibre optique d'analyse du faisceau optique transmis à travers le cristal.

Selon une autre variante de réalisation, le dispositif selon l'invention comporte un deuxième élément photo-détecteur relié à un séparateur de polarisation, le séparateur de polarisation étant inséré entre le circulateur et la fibre optique et transmettant au deuxième élément photo-détecteur la composante des ondes réfléchies dont l'axe de polarisation est en quadrature par rapport à l'axe de polarisation de la fibre le signal électrique produit par le deuxième élément photo-détecteur étant transmis aux moyens de contrôle. Les moyens de contrôle combinent les signaux électriques provenant des deux éléments photo-détecteurs pour déterminer la valeur de la longueur d'onde $\lambda$ à commander.

Le dispositif selon l'invention présente l'avantage de permettre la réalisation de mesures ponctuelles en différents points de la zone de l'espace où l'on désire mesurer le champ électrique ou électromagnétique existant. Il permet donc avantageusement de réaliser une cartographie du champ régnant.

De par la forme et la structure du capteur, le dispositif permet également d'effectuer des mesures du champ électromagnétique rayonné par un élément hyperfréquence monté sur un circuit imprimé et de déterminer ses paramètres de fonctionnement.

Le dispositif selon l'invention présente encore l'avantage de pouvoir réaliser des mesures avec des moyens d'analyse largement déportés, situés, en particulier, en dehors de la zone d'acquisition des mesures

D'autres caractéristiques et avantages pourront apparaître au fil de la description réalisée en regard des figures annotées qui représentent:

la figure 1, la structure d'un dispositif de type polariseur / analyseur selon l'art antérieur,
la figure 2, la structure type décrivant les principaux éléments du dispositif selon l'invention,
la figure 3, Une représentation graphique associant les courbes de variation, en fonction de la longueur d'onde du faisceau émis, de l'intensité du signal électrique fourni par l'élément photo-détecteur pour un état physique du dispositif donné et la courbe de variation de la sensibilité du capteur,
la figure 4, la structure schématique du capteur selon l'invention,
la figure 5, la structure type décrivant les principaux éléments d'une variante de réalisation du dispositif selon l'invention,

Dans un souci d'éviter les énumérations, la suite de la description est faite en référence à une mesure de champ électromagnétique. Sauf indication contraire par "champ électromagnétique" il faut entendre "champ électrique, magnétique ou électromagnétique": la nature du champ mesuré étant sans rapport avec l'objet du dispositif couvert par l'invention.

Le but de la description qui suit n'est pas de décrire le fonctionnement dynamique du dispositif selon l'invention qui repose sur des principes connus de détection d'une variation du champ électromagnétique qui vient modifier les caractéristiques de biréfringence d'un capteur électro-optique, mais plutôt de décrire un fonctionnement statique en s'intéressant à la façon d'assurer un point de polarisation qui permette un fonctionnement dynamique linéaire du capteur avec une sensibilité maximale, et ce indépendamment des variations des conditions du milieu dans lequel est réalisée la mesure, comme les variations de température par exemple. Seules seront citées en cours de rédaction les caractéristiques relatives au fonctionnement dynamique qui présentent un avantage par rapport à l'art antérieur.

En pratique le fonctionnement du dispositif selon l'invention peut être décrit comme la superposition d'un fonctionnement qui gère les variations basses fréquences des caractéristiques optiques du dispositif, variations qui sont en particulier dues à l'influence des variations locales de température sur le capteur électro-optique et sur la fibre à maintien de polarisation, et d'un fonctionnement qui gère les variations rapides de ces caractéristiques, essentiellement dues à l'action du champ mesuré sur le capteur électro-optique.

La figure 1, qui illustre le principe général de fonctionnement des dispositifs électro-optiques de type polariseur /analyseur déjà connus de l'art antérieur, permet d'appréhender le problème posé par l'influence de facteurs environnementaux sur de tels dispositifs. Parmi ces facteurs on trouve en premier lieu les variations de température ou l'application de contraintes mécaniques locales, accidentelles ou non. Ces facteurs ont pour effet de faire varier de manière aléatoire les caractéristiques de propagation des ondes lumineuses dans le capteur électro-optique 15 ainsi que dans la fibre optique pouvant être utilisée pour guider le faisceau émis 11 vers le capteur et collecter le faisceau réfléchi 17. Comme cela a été dit précédemment, cette influence est d'autant plus grande que le capteur se trouve déporté plus loin des autres éléments du dispositif de mesure, la longueur de la fibre optique utilisée étant alors importante. Le dispositif de correction du déphasage constitué par les lames 111 et 112 se trouve alors mis en défaut.

La figure 2 illustre la structure de base du dispositif selon l'invention. Comme cela a été dit précédemment, ce dispositif comporte principalement une voie de polarisation et une voie d'analyse, ces deux voies présentant un élément commun constitué par une fibre optique à maintien de polarisation 24.

**EP 1 674 878 B1**

La voie de polarisation comporte une source lumineuse 21 polarisée, une source laser par exemple. Selon l'invention, cette source émet un faisceau lumineux 22 dont la longueur d'onde λ peut varier sous l'action d'un signal de commande 212. Le faisceau lumineux 22 est acheminé jusqu'à un capteur électro-optique 23 au travers d'une fibre optique à maintien de polarisation 24. La fibre optique à maintien de polarisation présente l'avantage de guider de manière séparée deux ondes lumineuses polarisées linéairement selon les axes diélectriques principaux de la fibre optique, c'est-à-dire les guider en éliminant tout couplage entre ces deux ondes. Les deux ondes lumineuses qui présentent une polarisation orientée selon un des axes propres de la fibre à maintien de polarisation subissent un déphasage important et différent de par les indices de réfraction différents qu'elles voient. Dans le cas du dispositif selon l'invention la fibre optique et la source sont connectées de façon à ce que l'axe de polarisation linéaire du faisceau émis coïncide avec l'un des axes diélectriques propres de la fibre. Ainsi la polarisation du faisceau émis est maintenue constante tout au long du trajet du faisceau dans la fibre.

Le capteur électro-optique 23 comporte une face réfléchissante 25 qui réfléchit les ondes lumineuses traversant le capteur, laquelle face est opposée à la face par laquelle pénètre le faisceau lumineux dans le capteur. Ce capteur est constitué principalement d'un matériau ayant des propriétés électro-optiques de type Niobate de lithium par exemple dont on met à profit les propriétés de biréfringence. Cette biréfringence se caractérise par la présence dans le capteur de deux axes diélectriques propres orthogonaux pour lesquels le matériau constituant le capteur présente des indices de réfractions différents. De manière connue, un des indices est appelé indice ordinaire, et l'autre indice extraordinaire. Cette différence d'indice se traduit par des vitesses de propagation différentes des ondes lumineuses.

La connexion entre la fibre optique 24 et le capteur 23 est réalisée de façon à ce que l'axe de polarisation du faisceau émis présente un angle sensiblement égal à 45˚ avec chacun des axes diélectriques propres du capteur. Ainsi, le faisceau émis se trouve divisé en deux ondes incidentes qui se propagent dans le capteur à des vitesses différentes et avec des axes de polarisation perpendiculaires. Les deux ondes ainsi créées se réfléchissent sur la paroi réfléchissante 25, et ressortent du capteur.

Ces ondes issues de la décomposition du faisceau incident présentent des axes de polarisation faisant un angle sensiblement égal à 45˚ avec la direction de polarisation privilégiée de la fibre. Ces ondes sont donc à leur tour décomposées durant leur transit au travers de la fibre optique et se recombinent pour former deux faisceaux réfléchis dont l'une présente un axe de polarisation aligné avec l'axe de propagation privilégié de la fibre optique et dont l'autre présente un axe de polarisation perpendiculaire. Les deux ondes réfléchies se propagent ainsi avec des vitesses différentes au travers de la fibre optique, vers la voie d'analyse.

La voie d'analyse se compose principalement de la fibre optique 24, d'un circulateur optique 27 à maintien de polarisation, placé entre la fibre à maintien de polarisation 24 et la source lumineuse 21. Elle comporte également un élément photo-détecteur 28 placé en sortie du circulateur 27.

Le circulateur 27 est ici employé principalement comme séparateur de polarisation et permet ainsi de sélectionner celui des faisceaux lumineux réfléchis, transmis par la fibre, dont l'axe de polarisation est orienté selon l'axe de propagation privilégié de la fibre. Le faisceau ainsi sélectionné est dirigé vers l'élément photo-détecteur 28. Le faisceau transmis est reçu par l'élément photo-détecteur qui délivre un signal électrique, une tension par exemple, directement proportionnelle à la puissance lumineuse du faisceau, intensité qui est elle-même fonction de la différence de phase entre les deux ondes réfléchies qui proviennent du capteur électro-optique 23 et qui forment ce faisceau après recombinaison par la fibre optique 24.

Avantageusement l'élément photo-détecteur peut remplir une fonction de filtrage fréquentiel, en séparant le signal électrique en un signal basse fréquence 210 correspondant à une variation de position du point de polarisation et un signal haute fréquence 29 correspondant à l'intensité du champ électromagnétique mesuré.

Le signal basse fréquence, correspondant en particulier à une variation du point de polarisation optique du capteur, produit par l'élément photo-détecteur est utilisé par le dispositif de contrôle 211 pour compenser cette variation en modifiant la longueur d'onde émise par la source 21 et ramener le point de polarisation à sa position initiale.

Il est à noter que l'avantage principal du dispositif selon l'invention, réside dans l'emploi simultané d'une source lumineuse 21 de longueur d'onde variable et d'une fibre optique à maintien de polarisation 24 intervenant à la fois au niveau du circuit de polarisation et du circuit d'analyse de l'état de polarisation l'onde optique. Cet arrangement particulier permet avantageusement de réaliser l'analyse du signal optique réfléchi au travers des faisceaux réfléchis formé à l'entrée de la fibre 24 qui combinent les ondes réfléchies sortant du capteur 23 suivant ses deux axes diélectriques propres. Chacun de ces faisceaux réfléchis pouvant être analysé indépendamment de l'autre, les variations de biréfringence de la fibre, qui sont notamment fonction des variations de température et qui modifient le déphasage relatif entre les faisceaux réfléchis, se propageant selon les axes diélectriques propres de la fibre, n'interviennent pas dans l'analyse. La longueur de la fibre optique n'est ainsi plus limitée. Et l'on peut à ce titre considérer que l'analyse du signal optique réfléchi est réalisée par la fibre 24 directement en sortie du capteur.

Pour bien comprendre le principe de fonctionnement du dispositif selon l'invention et en quoi il apporte une solution avantageuse au problème posé il est nécessaire de s'intéresser à la façon dont le faisceau émis par la source optique 21 est modifié au cours de son passage dans le dispositif.

En utilisant le formalisme matriciel de Jones, pour décrire la propagation du faisceau lumineux dans le dispositif, il est possible de calculer l'état de polarisation du faisceau lumineux en tout point du dispositif. Des calculs menés par ailleurs et non développés ici, montrent que, si l'on considère une absence d'anisotropie en absorption, la sensibilité maximale de mesure que l'on peut obtenir avec un dispositif tel que le dispositif selon l'invention, dans une configuration utilisant la modulation d'état de polarisation, est donnée par $|S_{\phi E}| = 1/2$. Cette sensibilité maximale peut être notamment obtenue lorsque le faisceau lumineux arrivant sur le cristal constituant le capteur électro-optique 23, est polarisé linéairement à 45˚ des axes diélectriques propres du cristal, comme cela est réalisé dans le dispositif selon l'invention.

L'état de polarisation initial du faisceau lumineux après sa première traversée dans le circulateur polarisant est donné par le vecteur de Jones suivant:

$$J = \begin{pmatrix} 1 \\ 0 \end{pmatrix} \qquad\qquad [1]$$

Dans son trajet à l'intérieur du dispositif, ce faisceau 22 émis par la source traverse ensuite successivement la fibre à maintien de polarisation 24, le capteur électro-optique 23, en aller-retour, puis de nouveau la fibre à maintien de polarisation 24, et enfin le circulateur polarisant 27. Les matrices de transfert (en l'absence de défauts d'orientation) associées aux divers éléments ont pour expression:

$$M_{capteur} = \begin{bmatrix} e^{-j\frac{\Delta\phi}{2}} & 0 \\ 0 & e^{j\frac{\Delta\phi}{2}} \end{bmatrix} . \qquad\qquad [2]$$

$$M_{fibre} = \begin{bmatrix} e^{-j\frac{\theta}{2}} & 0 \\ 0 & e^{j\frac{\theta}{2}} \end{bmatrix} \qquad\qquad [3]$$

$$M_{polariseur} = \begin{bmatrix} 0 & 0 \\ 0 & 1 \end{bmatrix} \qquad\qquad [4]$$

Dans les relations précédentes, $\theta$ et $\Delta\phi$ représentent respectivement les déphasages introduits entre les ondes se propageant selon les deux axes diélectriques propres de la fibre à maintien de polarisation 24 et du capteur électro-optique 23. $\Delta\phi$ contient en particulier l'information utile se rapportant à l'amplitude du champ électromagnétique mesuré. Par suite on peut écrire:

$$\Delta\phi = \phi_0 + \phi_E \qquad\qquad [5]$$

avec

$$\text{avec } \phi_E = \frac{2\pi L_{eff}}{\lambda} \cdot \Delta\vec{K} \cdot \vec{E} \qquad\qquad [6]$$

$L_{eff}$ est la longueur effective de cristal traversée par le faisceau lumineux et $\Delta\vec{K}$ est le vecteur sensibilité caractéristique du cristal constituant le capteur électro-optique utilisé. On rappelle que la longueur effective correspond à la longueur du cristal divisé par son indice de réfaction extraordinaire. $\phi_0$ quant à lui est fonction de la nature et de la structure du cristal qui constitue le capteur. Il est notamment fonction des indices de réfraction ordinaire et extraordinaire du cristal, indices qui sont en particulier variables avec les conditions environnementales, la température par exemple, du milieu dans lequel est situé le capteur. Les autres éléments optiques sont considérés comme isotropes et n'ont pas d'effet sur l'état de polarisation du faisceau lumineux. Ils ne sont donc pas pris en compte.

La matrice de Jones associée à l'ensemble du dispositif selon l'invention a pour expression générale:

$$M = M_{fibre} \cdot M_{polariseur} \cdot R_{-\alpha} \cdot M_{capteur} \cdot R_{\alpha} \cdot M_{polariseur} \cdot M_{fibre} \quad [7]$$

où les matrices de rotation $R_{\alpha}$ et $R_{-\alpha}$ permettant de passer du repère propre d'un élément optique à celui du suivant, sont définies par :

$$R_{\alpha} = \begin{bmatrix} \cos\alpha & \sin\alpha \\ -\sin\alpha & \cos\alpha \end{bmatrix} \quad [8]$$

Dans le cas du dispositif selon l'invention l'angle $\phi$ a pour valeur $\pi/4$, compte tenu du positionnement relatif des axes diélectriques propres de la fibre à maintien de polarisation 24 et du capteur 23 et de la façon dont la fibre est connectée au capteur.

L'état de polarisation du faisceau qui arrive finalement sur l'élément photo-détecteur 28 est donné par le produit de la matrice du dispositif [7] par le vecteur de Jones représentatif de la polarisation initiale [1]. La puissance optique normalisée P reçue sur la photodiode est par suite égale au carré du module de la seconde composante du vecteur de Jones, seule composante non nulle, issu du calcul précédent. Après simplification cette puissance optique reçue a pour expression:

$$P = \sin\left(\frac{\Delta\phi}{2}\right)^2 \quad [9]$$

La puissance optique étant normalisée, on constate que la variation de puissance optique reçue par le photo-détecteur est indépendante du déphasage $\theta$ introduit par la fibre optique.

Cette indépendance est par ailleurs justifiée de manière physique par le fait que, comme il a été dit précédemment, celle-ci fait partie à la fois de la voie de polarisation et de la voie d'analyse. De ce fait, les variations des caractéristiques propres de la fibre se trouvent intégrées dans le principe de la mesure sans induire de biais sur la valeur de la puissance optique reçue par l'élément photo-détecteur. Par suite, la fibre optique n'intervenant pas dans l'expression de la puissance optique reçue par le photo-détecteur, le dispositif selon l'invention peut avantageusement comporter une fibre optique 24 de grande longueur, plusieurs centaines de mètres par exemple.

On constate d'autre part que d'après la relation [9] le dispositif selon l'invention ouvre avantageusement la possibilité de contrôler le déphasage induit au niveau du capteur par le phénomène de biréfringence.

Connaissant l'expression de P, il est par ailleurs possible de déterminer le meilleur point de fonctionnement du capteur, sachant que la sensibilité $S_{\phi E}$ dudit capteur est liée à la variation de la puissance optique reçue par le photo-détecteur, par la relation suivante:

$$S_{\phi E} = \left(\frac{\partial P(\Delta\phi)}{\partial \phi_E}\right)_{\phi_E \to 0} = 2 \cdot \sin\left(\frac{\Delta\phi}{2}\right) \quad [10]$$

Le meilleur point de fonctionnement, permettant un fonctionnement linéaire du dispositif étant déterminé pour la valeur de $\Delta\phi$ qui correspond une sensibilité $S_{\phi E}$ maximum du capteur électro-optique, on constate que le point de fonctionnement optimum correspond à un déphasage des ondes produites par la biréfringence du capteur égal à $\Delta\phi =$

$\pi/4$. Pour maintenir constant ce point de fonctionnement il faut donc assurer une polarisation variable du cristal constituant le capteur, capable de corriger en particulier les variations de la composante $\phi_0$ du déphasage induit par le capteur, consécutives à la fois à la nature biréfringente du cristal et aux variations de conditions environnementales, telles que des variations de température, qui induisent des indices de réfraction du cristal.

Les équations de Sellmeir, connues par ailleurs et non énoncées ici, permettent de déterminer que les indices de réfraction ordinaire et extraordinaire qui caractérisent un cristal de structure donnée sont en particulier fonction de la longueur d'onde de l'onde lumineuse qui traverse le cristal, et de la température ambiante. On peut donc écrire: ne = $f_1(\lambda, T)$ et $n_o = f_2(\lambda, T)$. Par suite, le déphasage $\phi_o$, en l'absence de champ appliqué, va dépendre des indices ne et $n_o$ du cristal constituant le capteur, de la longueur d'onde $\lambda$ de l'onde lumineuse traversant le capteur ;il a pour expression:

$$\phi_o(\lambda) = \frac{2 \cdot \pi \cdot \text{Leff}}{\lambda} \cdot \left( n_e(\lambda) - n_o(\lambda) \right) \qquad [11]$$

où $L_{eff}$ représente la longueur effective du cristal et $\lambda$ la longueur d'onde de l'onde lumineuse traversant le cristal.

On constate donc à partir des relations [9], [10] et [11] qu'à l'aide du dispositif selon l'invention, il est avantageusement possible de polariser le capteur électro-optique de façon à obtenir une sensibilité maximale, et que cette polarisation peut être réalisée en jouant simplement sur la longueur d'onde traversant le capteur. On constate également que la variation $\phi_-e$ du déphasage $\phi_o$ est indépendante des paramètres de la fibre 24 utilisée.

D'autre part, les relations [10] et [11] permetent de constater qu'en choisissant une longueur de cristal et une variation de longueur d'onde compatibles il est possible d'obtenir la sensibilité optimale pour une valeur donnée de P correspondant à la moitié de la valeur maximale du signal électrique délivré par le photo-détecteur.

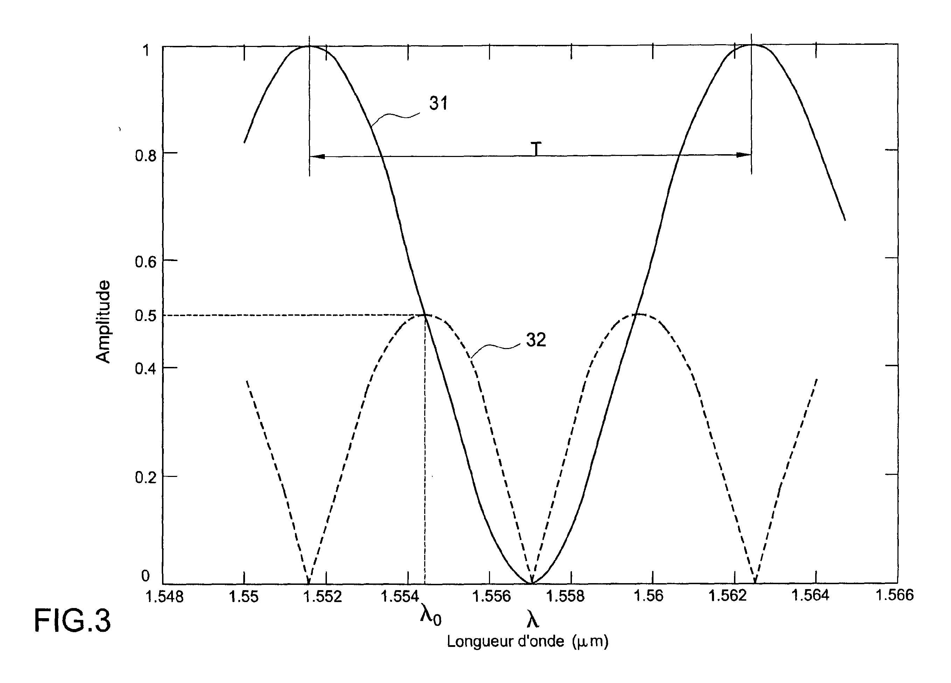

La figure 3 illustre ces constatations théoriques. Elle présente une courbe type 31 de variation, en fonction de la longueur d'onde, $\lambda$, de l'onde lumineuse émise par la source 21, de la puissance optique normalisée P reçue par le photo-détecteur. Elle présente également la courbe type 32 correspondante représent la variation de la sensibilité du capteur en fonction de $\lambda$. Comme on peut le constater sur la figure ces courbes sont périodiques de période T et T/2 et varient entre des valeurs max. et des valeurs min. La période T, ainsi que la position des extrema sur l'axe des longueurs d'ondes sont fonction des caractéristiques physiques et structurelles du cristal constituant le capteur 23 et en particulier de la longueur du cristal selon la direction de propagation. Ainsi plus la longueur du cristal est faible et plus la période T est grande.

Un changement des caractéristiques physiques du cristal, en particulier sous l'action de la température, se traduit par une translation simultanée des deux courbes sur l'axe des longueurs d'ondes.

Comme on peut également le constater sur la figure 3, la sensibilité du capteur, définie par la relation [10], est maximale lorsque l'amplitude du signal délivré par le photo-détecteur est alors égale à la moitié de l'amplitude maximale. Ce maximum de sensibilité est par ailleurs atteint, comme il a été dit précédemment, pour une valeur $\lambda_0$ de la longueur d'onde qui dépend des caractéristiques du cristal qui constitue le capteur, ainsi que des conditions environnementales. Une variation, même faible, de ces paramètres, en particulier de la température ambiante, aura pour effet de translater ces courbes le long de l'axe des longueurs d'ondes et de positionner ainsi le point de sensibilité maximale à une longueur d'onde $\lambda_1$ différente de $\lambda_0$.

Une mise en oeuvre optimale d'un capteur électro-optique selon l'invention consiste donc à le faire traverser par une onde lumineuse dont la longueur d'onde peut varier en fonction des variations du milieu ambiant de façon à ce que cette longueur d'onde coïncide toujours avec le point de sensibilité maximum.

A cet effet le dispositif selon l'invention est avantageusement pourvu d'un dispositif de contrôle 211 qui permet de réaliser l'asservissement de la longueur d'onde $\lambda$ émise par la source 21.

Le fonctionnement de ce circuit de contrôle 211 par ailleurs classique n'est pas ici décrit dans le détail. On notera simplement que l'asservissement peut être réalisé en analysant la variation du signal BF délivré par l'élément photo-détecteur 28, par rapport à une consigne correspondant au signal BF reçu par les moyens de contrôle lorsque la sensibilité maximum est atteinte.

A cet effet la valeur de consigne peut être déterminée durant une phase de fonctionnement du dispositif, dédiée par exemple à la calibration, durant laquelle la source 21 balaye l'ensemble des longueurs d'ondes qui constitue sa plage de fonctionnement pendant que les moyens de contrôle effectuent l'acquisition des valeurs correspondantes de l'amplitude du signal 210 fourni par le photo-détecteur 28.

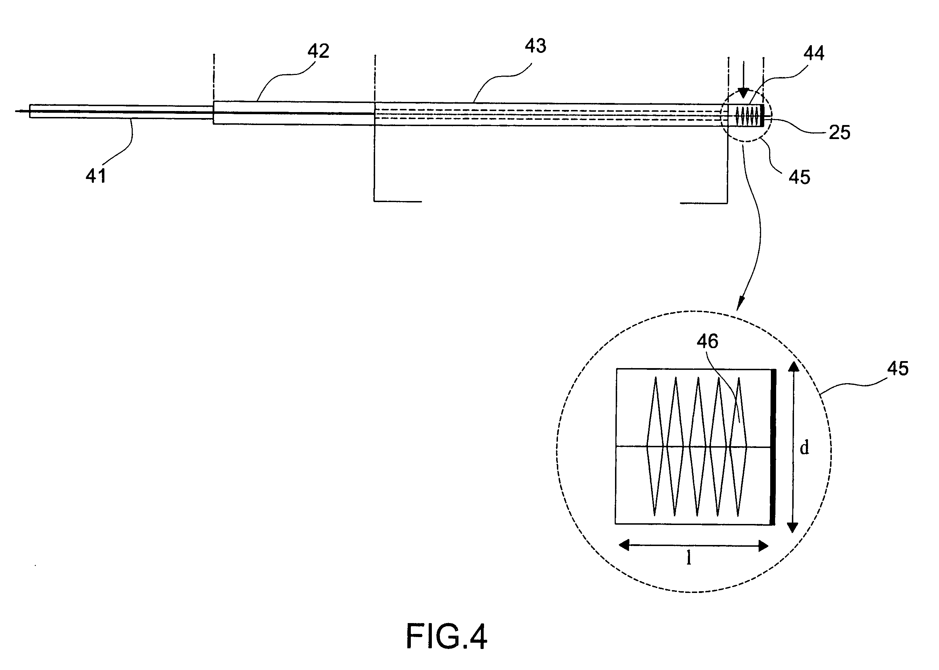

La figure 4 est une représentation schématique du capteur 23 du dispositif selon l'invention.

Comme le montre cette figure le capteur du dispositif selon l'invention possède une structure particulière formée de plusieurs éléments. Le capteur comporte ainsi de manière classique des éléments 41 et 42 permettant la connexion du cristal constituant le capteur à la fibre optique 24. L'élément 41 est par exemple constitué par une portion de fibre optique permettant le raccordement du capteur 23 à la fibre optique 24 par l'intermédiaire d'un élément de connectique approprié.

L'élément 42 permettant le raccordement de l'élément 41 aux éléments 43 et 44 du capteur, constitués du cristal électo-optique proprement dit, peut par exemple consister en une ferrule de verre.

La partie caractéristique du capteur du dispositif selon l'invention est constituée des éléments 43 et 44. Ces éléments sont généralement réalisés dans le même matériau électro-optique.

L'élément 43, ou élément de polarisation, a pour fonction de permettre de réaliser une polarisation optimale du point de fonctionnement de l'ensemble du capteur. A cet effet sa longueur L est définie de façon à ce que compte tenu de la plage de variation envisagée pour les caractéristiques de réfringence du capteur et de la taille de la plage de longueurs d'ondes pouvant être balayée par la source 21, cette longueur soit suffisante pour permettre, en cas de modification des caractéristiques du capteur sous l'effet de la témpérature par exemple, de modifier la longueur d'onde $\lambda_0$ émise en vue d'émettre la longueur d'onde $\lambda_1$ correspondant à la nouvelle position du point de sensibilité maximum tel qu'elle a été définie à l'occasion du commentaire de la figure 3. Autrement dit, la longueur de l'élément 43, qui conditionne fortement la longueur du capteur, est déterminée par la plage de variation maximum des caractéristiques du capteur et la plage de variation maximum de la longueur d'onde pouvant être émise par la source.

L'élément 44, quant à lui représente la partie capteur proprement dite du dispositif selon l'invention. Il représente un capteur ponctuel permettant de détecter la variation du champ électromagnétique présent dans la zone de l'espace ou il est placé. A cet effet sa longueur L est très inférieure à la longueur d'onde maximum du champ que l'on souhaite mesurer. Ainsi par exemple pour un capteur dédié à la mesure d'un champ électromagnétique dont la fréquence est voisine de la dizaine de GHz, la longueur L du capteur sera de l'ordre du mm. L'élément 44 se présente donc comme une fine pastille de matériau électro-optique dont une des faces 25 est réfléchissante.

Le capteur du dispositif selon l'invention se présente ainsi comme une petite baguette cylindrique ou rectangulaire de quelques cm de longueur et quelques mm de section, terminée par un élément de fibre optique et portant à son extrémité libre une pastille constituant la partie active.

Selon des variantes de réalisation de l'invention, le dispositif peut comporter un capteur comportant lui-même un élément 44 constitué simplement par la portion terminale du cristal constituant le capteur, ou bien un élément dont la surface présente des petites surfaces géométriques 46 sur lesquelles est déposé, soit une couche de matériau résistif, comme par exemple du $Ni_{80}Cr_{20}$, soit encore un dépôt métallique. Un tel élément est illustré dans l'encadré 45 de la figure 4.

Le dispositif selon l'invention tel que présenté à titre d'exemple à la figure 2 représente une forme préférée de réalisation. Néanmoins il est possible de mettre en oeuvre des variantes de réalisation présentant les mêmes caractéristiques essentielles. Il est par exemple possible de réaliser un dispositif comportant un capteur 23 ne présentant pas de surface terminale réfléchissante 25. Dans ce cas le faisceau émis par la source 21 parcourt la voie de polarisation constituée par une première fibre optique à maintien de polarisation 24, traverse le capteur sous la forme de deux ondes se propageant à des vitesses différentes chacune suivant un des axes diélectriques propres du cristal, puis parcourt la voie d'analyse constituée d'une deuxième fibre à maintien de polarisation et d'un séparateur de polarisation 27 pour aboutir à l'élément photo-détecteur.

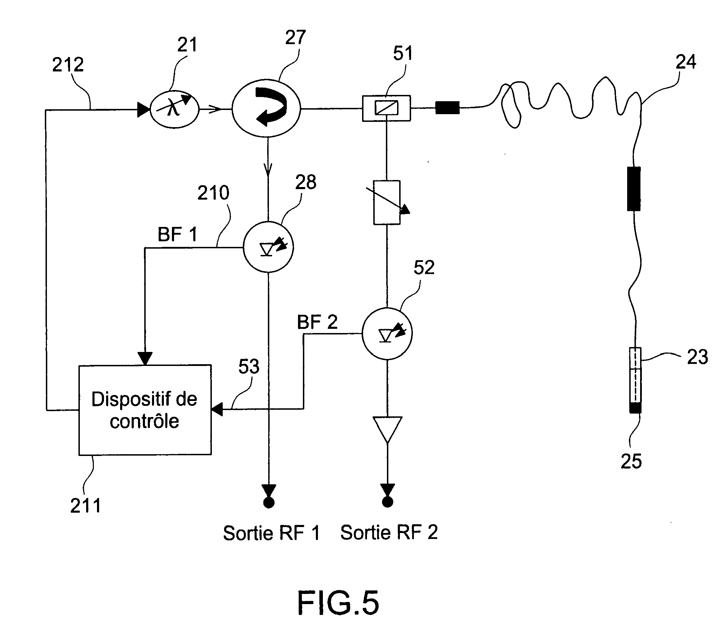

Un autre exemple de variante de réalisation peut consister à utiliser les deux faisceaux réfléchis formés par la fibre à partir des ondes réfléchies par le capteur, pour élaborer la fonction réalisée par les moyens de contrôle 211. Par rapport à la forme de réalisation préférée, cette variante de réalisation présentée à la figure 5 comporte en outre un élément séparateur de polarisation 51 placé entre la fibre optique 24 et le circulateur 25 et relié à un deuxième élément photo-détecteur 52, analogue au photo-détecteur 28, et fournissant aux moyens de contrôle 211 un signal électrique dont l'amplitude est proportionnelle à la puissance optique qu'il reçoit. Dans cette variante de réalisation, le faisceau lumineux réfléchi qui se propage selon l'axe de polarisation préférentiel de la fibre suit un chemin identique à celui suivi dans le dispositif original de la figure 2 : sa puissance est convertie en signal électrique par le photo-détecteur 28. En revanche, le deuxième faisceau réfléchi se propageant selon l'axe de polarisation perpendiculaire à l'axe préférentiel, inexploité dans le dispositif original, est dirigé par le séparateur de polarisation 51 vers le deuxième élément photo-détecteur 52 et converti en un deuxième signal électrique 53. Dans cette variante de réalisation basée sur le même principe de fonctionnement, les moyens de contrôle 211 des deux signaux électriques 210 et 53 pour élaborer le signal de commande 212 permettant d'asservir la longueur d'onde émise. Au lieu d'élaborer le signal 212 en comparant la valeur du signal électrique à une valeur de consigne, il est alors possible d'effectuer cette détermination par comparaison des variations relatives des deux signaux.

## Revendications

1. Dispositif électro-optique de mesure d'un champ électrique, magnétique ou électromagnétique comportant au moins:

- une source lumineuse (21) de longueur d'onde variable sur une plage déterminée et commandable par un signal, (212)
- Un capteur électro-optique (23) en matériau biréfringent comportant une face réfléchissante (25) à l'une de ses extrémités,

- un élément photo-détecteur (28) pour convertir le faisceau lumineux réfléchi par le capteur en un signal électrique (210) proportionnel à la puissance lumineuse reçue,

- des moyens de contrôle (211), permettant d'analyser le signal électrique (210) fourni par le photodétecteur (28) et de faire varier la valeur de la longueur d'onde λ émise par la source optique (21) en fonction de ce signal électrique (210),

- une fibre optique à maintien de polarisation (24), pour transporter des signaux optiques incident de la source lumineuse (21) vers le capteur (23) et les signaux optiques réfléchis par le capteur vers le photodétecteur (28), ladite fibre optique étant connectée au capteur (23) de façon à orienter l'axe de polarisation du signal émis dans une direction faisant un angle sensiblement égal à 45° par rapport aux directions de propagations définies dans l'élément biréfringent du capteur (23),

- un circulateur optique (27), placé entre la source lumineuse (21) et la fibre optique (24) d'une part et entre la fibre optique (24) et le détecteur (23) d'autre part,

**Caractérisé en ce que**:

- le circulateur optique est un circulateur à maintien de polarisation, apte à polariser linéairement l'onde optique λ produite par la source lumineuse (21) et transmise à la fibre (24), et à sélectionner celui des signaux lumineux réfléchis, transmis par le capteur (23), qui est polarisé suivant l'axe de propagation privilégié de la fibre optique (24),

- le capteur électro-optique, apte à décomposer le faisceau transmis par la fibre optique (24) et former deux ondes se propageant selon ses deux axes diélectriques propres, comporte deux parties :

    - un élément de polarisation (43) pour fixer le point de fonctionnement du capteur (23),
    - un élément terminal (44) sensible aux champs électriques et magnétiques, adjacent à l'élément de polarisationt (43), dont l'une des faces (25) est réfléchissante,

la longueur efficace Leff de l'élément de polarisation (43) étant déterminée, en fonction de la plage de variation de la longueur d'onde λ de la source optique (21), pour permettre, en faisant varier la longueur d'onde λ de la source optique, de faire varier sur 360° le déphasage relatif $\varphi_0$ entre les deux ondes formées dans le capteur (23), de façon à obtenir un déphasage relatif correspondant à la sensibilité maximale de ce capteur (23).

2. Dispositif selon la revendication 1, **caractérisé en ce que** le capteur électro-optique (23) se présente sous la forme d'un élément tubulaire ou rectangulaire allongé comportant en outre une zone d'extrémité (41, 42) assurant la connexion avec la fibre optique à maintien de polarisation (24), une zone biréfringente centrale (43) induisant un déphasage entre les ondes linéairement polarisées se propageant selon les axes diélectriques propres du cristal et une zone terminale (44) constituant le capteur de champ proprement dit.

3. Dispositif selon la revendication 2, **caractérisé en ce que** la longueur de la zone terminale (44) est égale à une fraction de la longueur d'onde du champ magnétique, électrique ou électromagnétique à mesurer.

4. Dispositif selon la revendication 3, **caractérisé en ce que** la zone terminale (44) comporte sur sa surface un ensemble de zones géométriques (46) juxtaposées, revêtues d'une couche de matériau résistif et formant une antenne adaptée à la longueur d'onde du champ à mesurer.

5. Dispositif selon la revendication 3, **caractérisé en ce que** la zone terminale (44) comporte sur sa surface un ensemble de zones géométriques (46) juxtaposées, revêtues d'une couche métallique et formant une antenne adaptée à la longueur d'onde du champ à mesurer

6. Dispositif selon l'une des revendications précédentes, **caractérisé en ce qu'**il comporte en outre un deuxième élément photo-détecteur (52) relié à un séparateur de polarisation (51), le séparateur de polarisation étant inséré entre le circulateur optique (27) et la fibre optique (24) et transmettant au deuxième élément photo-détecteur (52) la composante des ondes réfléchies dont l'axe de polarisation est perpendiculaire par rapport à l'axe de polarisation principale de la fibre (24), un signal électrique (53) produit par le deuxième élément photo-détecteur étant transmis aux moyens de contrôle.

7. Dispositif selon la revendication 6, **caractérisé en ce que** les moyens de contrôle (211) détermine la valeur de la longueur d'onde λ à imposer à la source optique (21) par comparaison des variations relatives des signaux électriques (210, 53) produits par les deux éléments photo-détecteurs (28, 52).

**Claims**

1. Electro-optic device for measuring an electric, magnetic or electromagnetic field, comprising at least:

   - a light source (21) of a wavelength variable over a determined range and controllable by a signal (212);
   - an electro-optic sensor (23) made of a birefringent material comprising a reflective face (25) at one of its ends;
   - a photodetector element (28) for converting the light beam reflected by the sensor into an electrical signal (210) proportional to the light power received;
   - control means (211) allowing analysis of the electrical signal (210) provided by the photodetector (28) and variation of the value of the wavelength $\lambda$ emitted by the optical source (21) depending on this electrical signal (210);
   - a polarization-maintaining optical fibre (24) for transporting incident optical signals from the light source (21) towards the sensor (23) and the optical signals reflected by the sensor towards the photodetector (28), said optical fibre being connected to the sensor (23) so as to orient the polarization axis of the emitted signal in a direction making an angle approximately equal to 45˚ to the propagation directions defined in the birefringent element of the sensor (23); and
   - an optical circulator (27) placed between the light source (21) and the optical fibre (24) on the one hand and between the optical fibre (24) and the detector (28) on the other hand;

   **characterized in that**:

   - the optical circulator is a polarization-maintaining circulator able to linearly polarize the optical wave $\lambda$ produced by the light source (21) and transmitted by the fibre (24) and to select that reflected light signal, transmitted by the sensor (23), which is polarized along the privileged propagation axis of the optical fibre (24);
   - the electro-optic sensor, which is able to decompose the beam transmitted by the optical fibre (24) and form two waves propagating along its two dielectric eigenaxes, comprises two parts:

     - a polarization element (43) for fixing the point of operation of the sensor (23); and
     - a terminal element (44) sensitive to electrical and magnetic fields, adjacent to the polarization element (43), one face of which (25) is reflective; the effective length Leff of the polarization element (43) being determined, depending on the range of variation of the wavelength $\lambda$ of the optical source (21), in order to allow, by varying the wavelength $\lambda$ of the optical source, variation of the relative phase shift $\varphi_0$ between the two waves formed in the sensor (23) over 360˚ so as to obtain a relative phase shift corresponding to the maximum sensitivity of this sensor (23).

2. Device according to Claim 1, **characterized in that** the electro-optical sensor (23) exhibits the form of an elongate tubular or rectangular element additionally comprising an end area (41, 42) ensuring the connection with the polarization-maintaining optical fibre (24), a birefringent central area (43) causing a phase shift between the linearly polarized waves propagating along the dielectric eigenaxes of the crystal and a terminal area (44) constituting the field sensor itself.

3. Device according to Claim 2, **characterized in that** the length of the terminal area (44) is equal to a fraction of the wavelength of the magnetic, electric or electromagnetic field to be measured.

4. Device according to Claim 3, **characterized in that** the terminal area (44) comprises on its surface a set of juxtaposed geometric areas (46), covered with a layer of resistive material and forming an antenna suited to the wavelength of the field to be measured.

5. Device according to Claim 3, **characterized in that** the terminal area (44) comprises on its surface a set of juxtaposed geometric areas (46), covered with a layer of metallic material and forming an antenna suited to the wavelength of the field to be measured.

6. Device according to one of the preceding claims, **characterized in that** it furthermore comprises a second photodetector element (52) connected to a polarization splitter (51), the polarization splitter being inserted between the optical circulator (27) and the optical fibre (24) and transmitting to the second photodetector element (52) the component of the reflected waves whose polarization axis is perpendicular to the main polarization axis of the fibre (24), an electrical signal (53) produced by the second photodetector element being transmitted to the control means.

7. Device according to Claim 6, **characterized in that** the control means (211) determine the value of the wavelength λ to be set at the optical source (21) by comparing relative variations of the electrical signals (210, 53) produced by the two photodetector elements (28, 52).

**Patentansprüche**

1. Elektrooptische Vorrichtung des Masses eines elektrischen Feldes, magnetischen oder elektromagnetischen Felds, die mindestens Folgendes aufweist:

- eine Lichtquelle (21) mit einer Wellenlänge, die auf einem bestimmten Bereich variabel und durch ein Signal steuerbar ist, (212)
- einen elektrooptischen Sensor (23) aus doppelbrechendem Material mit einer reflektierenden Seite (25) an einem seiner Enden,
- ein lichtempfindliches Element (28) zum Umwandeln des durch den Sensor reflektierten Lichtbündels in ein elektrisches Signal (210), das zu der empfangenen Lichtleistung proportional ist,
- Prüfmittel (211), die es erlauben, das elektrische Signal (210), das von dem lichtempfindlichen Sensor (28) geliefert wird, zu analysieren und den Wert der Wellenlänge λ, die von der optischen Quelle (21) gesendet wird, in Abhängigkeit von diesem elektrischen Signal (210) variieren zu lassen,
- eine Lichtleitfaser mit Polarisationshalten (24) zum Transportieren der einfallenden optischen Signale der Lichtquelle (21) zu dem Sensor (23) und der von dem Sensor reflektierten optischen Signale zu dem lichtempfindlichen Element (28), wobei die Lichtleitfaser an den Sensor (23) derart angeschlossen ist, dass die Polarisationachse des gesendeten Signals in eine Richtung ausgerichtet wird, die einen Winkel von im Wesentlichen 45° zu den Ausbreitungsrichtungen bildet, die in dem doppelbrechenden Element des Sensors (23) definiert sind,
- einen optischen Zirkulator (27), der zwischen der Lichtquelle (21) und der Lichtleitfaser (24) einerseits und zwischen der Lichtleitfaser (24) und dem Sensor (23) andererseits platziert ist,

**dadurch gekennzeichnet, dass**:

- der optische Zirkulator ein Zirkulator mit Polarisationshalten ist, der die optische Welle λ, die von der Lichtquelle (21) erzeugt und von der Faser (24) übertragen wird, linear polarisieren kann, und dasjenige der reflektierten Lichtsignale auswählen kann, das von dem Sensor (23) übertragen wird, das entlang der privilegierten Ausbreitungachse der Lichtleitfaser (24) polarisiert ist,
- der elektrooptische Sensor, der das von der Lichtleitfaser (24) übertragene Bündel aufschlüsseln und zwei Wellen bilden kann, die sich entlang seiner zwei eigenen dielektrischen Achsen ausbreiten, zwei Teile aufweist:

  - ein Polarisationselement (43) zum Festlegen des Betriebspunkts des Sensors (23),
  - ein Abschlusselement (44), das auf elektrische und magnetische Felder reagiert, neben dem Polarisationselement (43), von dem eine der Seiten (25) reflektierend ist,

wobei die Wirklänge Leff des Polarisationselements (43) in Abhängigkeit von dem Variationsbereich der Wellenlänge λ der optischen Quelle (21) bestimmt wird, um es durch Variieren der Wellenlänge λ der optischen Quelle zu erlauben, die relative Phasenverschiebung $\varphi_0$ zwischen den zwei Wellen, die in dem Sensor (23) gebildet werden, auf 360° variieren zu lassen, um eine relative Phasenverschiebung zu erzielen, die der maximalen Empfindlichkeit dieses Sensors (23) entspricht.

2. Vorrichtung nach Anspruch 1, **dadurch gekennzeichnet, dass** der elektrooptische Sensor (23) die Form eines röhrenförmigen oder rechteckigen länglichen Elements hat, das ferner eine Endzone (41, 42) aufweist, die das Anschließen an die Lichtleitfaser mit Polarisationshalten (24) sicherstellt, wobei eine doppelbrechende zentrale Zone (43) eine Phasenverschiebung zwischen den linear polarisierten Wellen, die sich entlang der eigenen dielektrischen Achsen des Kristalls ausbreiten, und einer Endzone (44), die den eigentlichen Feldsensor bildet, induziert.

3. Vorrichtung nach Anspruch 2, **dadurch gekennzeichnet, dass** die Länge der Endzone (44) gleich einem Bruchteil der Wellenlänge des zu messenden magnetischen, elektrischen oder elektromagnetischen Felds ist.

4.  Vorrichtung nach Anspruch 3, **dadurch gekennzeichnet, dass** die Endzone (44) auf ihrer Oberfläche eine Einheit benachbarter geometrischer Zonen (46) aufweist, die mit einer Schicht aus resistivem Material beschichtet sind und eine Antenne bilden, die an die Wellenlänge des zu messenden Felds angepasst ist.

5.  Vorrichtung nach Anspruch 3, **dadurch gekennzeichnet, dass** die Endzone (44) auf ihrer Oberfläche eine Einheit benachbarter geometrischer Zonen (46) aufweist, die mit einer Metallschicht beschichtet sind, und die eine Antenne bilden, die an die Wellenlänge des zu messenden Felds angepasst ist.

6.  Vorrichtung nach einem der vorhergehenden Ansprüche, **dadurch gekennzeichnet, dass** sie ferner ein zweites lichtempfindliches Element (52) aufweist, das mit einem Polarisationstrenner (51) verbunden ist, wobei der Polarisationstrenner zwischen den optischen Zirkulator (27) und die Lichtleitfaser (24) eingefügt ist und an das zweite lichtempfindliche Element (52) die Komponente der reflektierten Wellen überträgt, deren Polarisationachse zu der Hauptpolarisationachse der Faser (24) senkrecht steht, und ein elektrisches Signal (53), das von dem zweiten lichtempfindlichen Element erzeugt wird, an die Steuermittel übertragen wird.

7.  Vorrichtung nach Anspruch 6, **dadurch gekennzeichnet, dass** die Steuermittel (211) den Wert der Wellenlänge $\lambda$, der der optischen Quelle (21) aufzuerlegen ist, durch Vergleichen der relativen Variationen der elektrischen Signale (210, 53), die von den zwei lichtempfindlichen Sensoren (28, 52) erzeugt werden, bestimmen.

FIG.1

FIG.2

FIG.3

EP 1 674 878 B1

FIG.4

EP 1 674 878 B1

Sortie RF 1    Sortie RF 2

FIG.5

EP 1 674 878 B1

## RÉFÉRENCES CITÉES DANS LA DESCRIPTION

**Littérature non-brevet citée dans la description**

- **MAZZOLA et al.** Gallium-arsenide optically isolated electric field sensor for utility and pulsed power applications. *PULSED POWER CONFERENCE,* 03 Juillet 1995

- **SHINICHI WAKANA et al.** Fiber-Edge Electrooptic/Magnetooptic Probe for Spectral-Domain Analysis of Electromagnetic Field. *IEEE Transactions on microwave theriory and techniques,* Décembre 2000, vol. 48 (12